(19)

Europäisches
Patentamt
European
Patent Office
Office européen
des brevets

(11) **EP 4 546 005 A1**

(12) **EUROPEAN PATENT APPLICATION**

(43) Date of publication:
**30.04.2025 Bulletin 2025/18**

(21) Application number: **24207091.0**

(22) Date of filing: **17.10.2024**

(51) International Patent Classification (IPC):
**G01S 7/481** (2006.01) **H05K 9/00** (2006.01)

(52) Cooperative Patent Classification (CPC):
**G01S 7/4813; H05K 9/0047**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.10.2023 FR 2311561**

(71) Applicant: **STMicroelectronics International N.V.
1228 Plan-les-Ouates, Geneva (CH)**

(72) Inventors:
• TEO, Tat Ming
797463 SINGAPORE (SG)
• MAO, Yandong
SHANGHAI, 200240 (CN)
• PRICE, Andrew John
BONNYRIGG, EH19 3BQ (GB)
• HALLIDAY, William
EDINBURGH, EH12 8EX (GB)

(74) Representative: **Cabinet Beaumont
4, Place Robert Schuman
B.P. 1529
38025 Grenoble Cedex 1 (FR)**

(54) **OPTICAL SENSOR MODULE**

(57) The present disclosure relates to an optical sensor module (100) comprising:
- a light-emitting device;
- a light-receiving sensor (122); and
- a module cap (130) adapted to at least partially cover the light-emitting device and the light-receiving sensor, the module cap being a molded cap, the molded cap being formed of a molding material comprising electrically conductive particles dispersed therein for providing electromagnetic interference shielding.

Fig 1A

Processed by Luminess, 75001 PARIS (FR)

EP 4 546 005 A1

## Description

Technical field

The present disclosure relates generally to optical sensors, in particular optical sensor modules.

Background art

Optical sensors, such as proximity sensors, may be used to detect the presence of nearby objects. Optical sensors are able to do so without physically touching the object. Some types of optical sensors, such as those utilized in optical ranging devices or time of flight sensors, may be used to determine the actual distance to such nearby objects. Optical sensors may be utilized in various electronic devices, such as cameras, phones, including smartphones, smartwatches, tablets, vehicles, machinery, and other devices for detecting the presence of and/or distance to nearby objects. After detecting the presence of the nearby object, the electronic device may be configured to perform a function, such as move a mechanical feature to a secure position, transmit an alarm signal, couple or uncouple an electrical communication, or any other desired function.

Optical sensors typically include components, such as a light-emitting device, a light-receiving sensor, and generally a processing device for processing signals received from the light-receiving sensor. The components of the optical sensor may be formed on a substrate, and a cap may be bonded to the substrate over the components, for example to protect them from damage, thereby forming an optical sensor module, also called optical sensor package. The cap is generally formed with a first opening located over the light-emitting device and a second opening located over the light-receiving sensor.

Generally described, the light-emitting device emits a light signal through the first opening. If an object is outside, and close enough to, the optical sensor module, the light signal may be reflected by the object towards the light-receiving sensor through the second opening. The light-receiving sensor may then generate an electrical signal indicative of the received light signal, which may be transmitted to the processing device for processing said received light signal, for example to determine the presence of, and/or distance to, the proximate object.

There is a need for improving optical sensor modules, in particular to address electronic magnetic interference (EMI) issues between an optical sensor module and another electronic device, for example an electronic device that incorporates the optical sensor module.

Summary of Invention

One embodiment addresses all or some of the drawbacks of known optical sensor modules.

One embodiment provides an optical sensor module comprising:

- a light-emitting device;
- a light-receiving sensor; and
- a module cap adapted to at least partially cover the light-emitting device and the light-receiving sensor, the module cap being a molded cap, the molded cap being formed of a molding material comprising electrically conductive particles dispersed therein for providing electromagnetic interference shielding.

One embodiment provides an optical sensor module comprising:

- a light-emitting device;
- a light-receiving sensor;
- a module cap adapted to at least partially cover the light-emitting device and the light-receiving sensor, the module cap being a molded cap;
- a substrate with which the module cap is assembled, the light-emitting device being included in a first die mounted on the substrate, and the light-receiving sensor being included in a second die mounted on the substrate;
- conductive leads assembled with, or included in, the module cap and coupled to first conductive pads of the substrate; and
- at least one cover glass covering at least one opening of the module cap, each cover glass comprising a conductive trace providing electromagnetic interference shielding, the conductive trace being coupled to the conductive leads.

In an embodiment, the molded cap is formed of a molding material comprising electrically conductive particles dispersed therein for providing electromagnetic interference shielding.

In an embodiment, the module cap is suitable for absorbing electromagnetic waves, and/or has a surface resistivity lower than $10^4$ ohms/square, and/or has a relative magnetic permeability higher than 100.

In an embodiment, the module cap is an injection molded cap, and/or the molding material is a resin, a liquid crystal polymer, or another engineering plastic.

In an embodiment, the electrically conductive particles comprise one or more of the following:

- carbon fibers;
- chopped carbon fibers;
- electroplated carbon fibers, such as Ni-plated carbon fibers;
- carbon nanotubes;
- conductive carbon black particles;
- stainless steel fibers.

In an embodiment, the module cap includes a metallic finishing layer for increasing electromagnetic interference shielding.

In an embodiment, the module cap includes a separation wall adapted to separate the light-emitting device and the light-receiving sensor.

In an embodiment, the module further comprises a substrate with which the module cap is assembled, the light-emitting device being included in a first die mounted on the substrate, and the light-receiving sensor being included in a second die mounted on the substrate.

In an embodiment, the module further comprises conductive leads assembled with, or included in, the module cap and coupled to first conductive pads of the substrate, for example using a conductive adhesive material, the substrate comprising a conductive rail configured to be at a fixed voltage such as ground, the conductive rail being for example coupled to at least one of the first conductive pads.

In an embodiment, the conductive leads are lead frames inserted into channels of the module cap or overmolded in said module cap.

In an embodiment, the conductive leads are conductive layers formed on surfaces of the module cap, such as by a direct structuring laser technique.

In an embodiment, the module cap comprises a first opening located over the light-emitting device and a second opening located over the light-receiving sensor; and the module further comprises:

- a first cover glass positioned in the first opening, or between the first opening and the light-emitting device, and adapted to transmit light signals emitted by the light-emitting device; and
- a second cover glass positioned in the second opening, or between the second opening and the light-receiving sensor, and adapted to transmit light signals reflected towards the light-receiving sensor.

In an embodiment, the first cover glass and/or the second cover glass includes a conductive trace providing electromagnetic interference shielding.

In an embodiment, the conductive trace is coupled to at least one of the conductive leads.

In an embodiment, each cover glass further includes second conductive pads coupled to the conductive trace, the conductive leads being coupled to the second conductive pads, for example using a conductive adhesive material.

In an embodiment, the first and/or second cover glass further includes at least a second conductive pad coupled to the conductive trace, the at least one of the conductive leads being coupled to said at least one second conductive pad, for example using a conductive adhesive material.

In an embodiment, the conductive trace comprises substantially linear portions in parallel with each other and separate with each other by a distance which is smaller than the wavelength of the electromagnetic signal to be attenuated, or is equal to a fraction of said wavelength.

In an embodiment, the conductive trace material comprises one or a plurality of the following materials: copper, aluminum, tungsten, titanium, gold, indium-tin oxide.

Brief description of drawings

The foregoing features and advantages, as well as others, will be described in detail in the following description of specific embodiments given by way of illustration and not limitation with reference to the accompanying drawings, in which:

Figure 1A is a 3-dimensional view of an optical sensor module according to an embodiment;

Figure 1B is an exploded 3-dimensional view of the optical sensor module of Figure 1A;

Figure 1C is a top view of the optical sensor module of Figure 1A;

Figure 1D is a cross-section view of the optical sensor module of Figure 1A;

Figure 2A is a top view of the cover glass of the optical sensor module of Figure 1A;

Figure 2B is a top view of another cover glass of an optical sensor module according to another embodiment;

Figure 3A is a 3-dimensional view of a module cap of an optical sensor module according to a further embodiment; and

Figure 3B is a cross-section view of the optical sensor module of Figure 3A.

Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, all the components of an optical sensor have not been detailed, the described embodiments being compatible with the usual optical sensors. For example, the light-emitting device, the light-receiving sensor, and other components of an optical sensor, such as a processing device, have not been detailed. Similarly, all the components of an optical sensor module have not been detailed, the described embodiments being compatible with the usual optical sensor modules.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures, or to an optical sensor module as orientated during normal use.

Unless specified otherwise, the expressions "around", "approximately", "substantially" and "in the order of" signify within 10 %, and preferably within 5 %.

In the following disclosure, unless indicated otherwise, when reference is made to a resistivity, reference is made to an electrical resistivity. Similarly, when reference is made to a conductive element, reference is made to an electrically conductive element.

The term "optical sensor module" includes, without being limited to, a proximity sensor module, a time of flight (ToF) module, an ambient light sensor (ALS) module, a 3D Lidar module, and/or a camera module. The term optical sensor module also includes an optical sensor module with combined functions, for example a combination of at least two of the above-mentioned modules, or other functions, for example a combination of a proximity detector module with a floodlight and/or a dot projector.

The embodiments relate to optical sensor modules. An optical sensor typically includes a light-emitting device, for example a light emitting diode (LED), or a laser such as a vertical cavity surface emitting laser (VCSEL), and a light-receiving sensor, such as a photodiode or a plurality of photodiodes. An optical sensor generally also includes a processing device for processing signals received from the light-receiving sensor. The light-emitting device and the light-receiving sensor may be formed on a substrate, for example each in a different die attached to the substrate, and a cap may be bonded to the substrate over the light-emitting device and the light-receiving sensor, thereby forming an optical sensor module, also called optical sensor package. The cap is generally formed with a first opening located over the light-emitting device and a second opening located over the light-receiving sensor.

The optical sensor module may be affected by electromagnetic interferences (EMI) with another electronic device.

For example, when the optical sensor module is included in an electronic device (host device), electromagnetic interferences (EMI) may occur between the optical sensor module and the host device. The electronic device may be a camera, a phone, for example a smartphone, a smartwatch, a tablet, a vehicle, a machinery, or another device for which it may be useful to detect the presence of and/or distance to nearby objects.

The electromagnetic interferences between the optical sensor module and the host device may comprise:

- electromagnetic waves emitted by components of the optical sensor module which may affect components of the host device; and/or
- electromagnetic waves emitted by the host device which may affect the performance of the optical sensor module.

In addition, environments, such as environments having huge electromagnetic waves, for example data centres, may also interfere with components of the optical sensor module and affect its performance.

One solution to address the electromagnetic interference issues is to add a metal shield over the optical sensor module, in particular over electromagnetic sensitive components of the optical sensor module.

The metal of the metal shield is preferably selected to:

- reflect and/or absorb electromagnetic waves generated by the optical sensor module to prevent the electromagnetic waves from exiting the optical sensor module and affecting the host device, and/or
- reflect and/or absorb electromagnetic waves generated by the host device or electromagnetic waves coming from the environment, to prevent the electromagnetic waves from affecting the performance of the optical sensor module.

The metal shield may be grounded to further improve the effectiveness of EMI protection, for example for effective absorption of electric fields.

However, a metal shield can have a certain number of drawbacks, for example it may increase the footprint of the optical sensor module. Depending on the method used, the fabrication of a metal shield may introduce a large number of steps and/or induce high production costs, may need large tolerance which can for example be problematic for a small optical sensor module, and/or may be inefficient to form complex shapes. The fabrication may also introduce gaps in the metal shield which can allow electromagnetic waves to pass through. The choice of the material for the metal shield may also be limited. Moreover, there may be difficulties to implement a grounding scheme on the metal shield.

In addition to the above-mentioned possible drawbacks, another problem is that the openings in the optical sensor module involve having openings in the metal shield, the openings being then not shielded, which can allow electromagnetic waves to pass through. The dimensions of the openings may be adapted to manage electromagnetic interferences, depending on the frequency of the electromagnetic waves. For example, the opening dimensions may be comprised between 1 and 5 mm, or even between 0.1 and 5 mm. However, for certain frequencies, for example frequencies higher than 20 GHz, or higher than 30 GHz, or even higher than 300 GHz, an opening of 5 mm, 1 mm, or even 0.5 mm may be too large to manage EMI.

The inventors propose an optical sensor module making it possible to overcome all or part of the aforementioned drawbacks, in particular to address the electromagnetic interference issues, using a simple solution which can avoid increasing the footprint of the optical sensor module and complexifying the fabrication method, and which makes it possible to form complex shapes with low tolerance.

It may also be desirable that the solution can manage the electromagnetic interferences through the openings.

Embodiments of optical sensor modules will be described below. These embodiments are non-limiting and various variants will appear to the person skilled in the art from the indications of the present description.

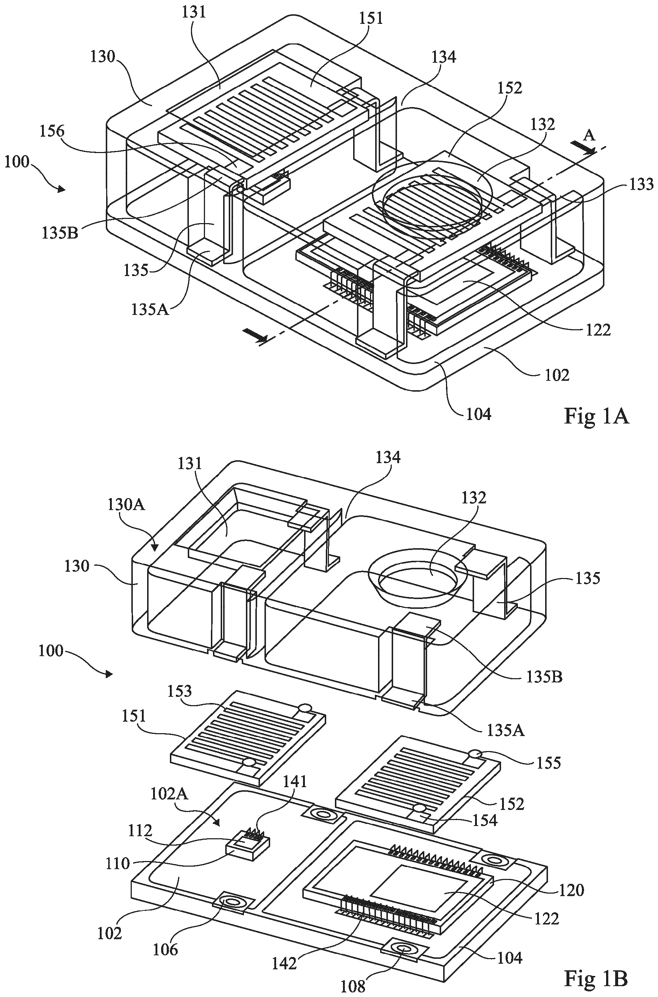

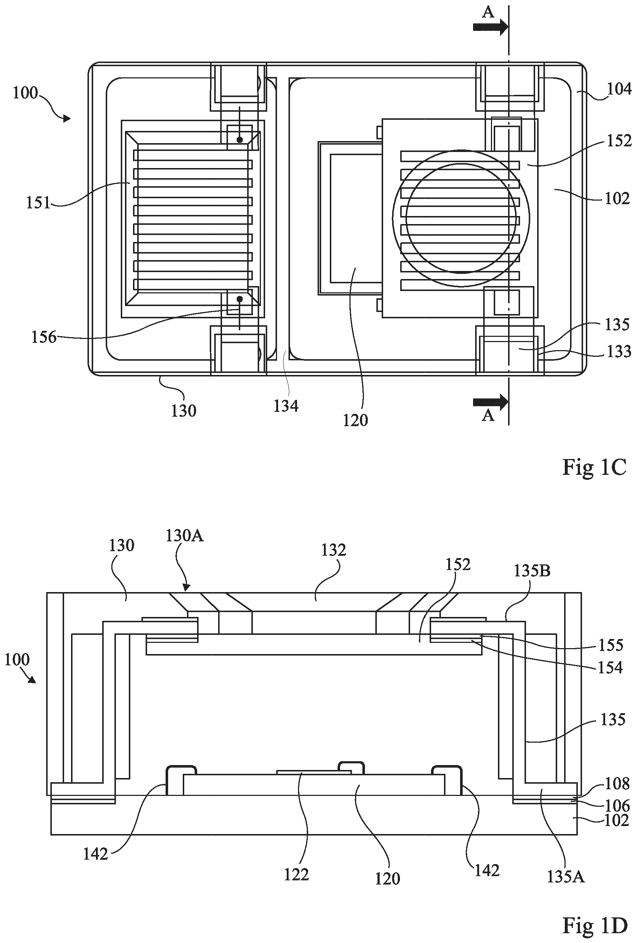

Figure 1A is a 3-dimensional view of an optical sensor module 100 according to an embodiment. Figure 1B is an exploded 3-dimensional view of the optical sensor module of Figure 1A. The exploded view of Figure 1B makes it easier to see the different components of the optical sensor module 100. Figure 1C is a top view of the optical sensor module of Figure 1A. Figure 1D is a cross-section view of the optical sensor module of Figure 1A. The cross-section is in the AA direction, which can be seen in Figure 1A and Figure 1C.

The optical sensor module 100 comprises a light-emitting device 112, for example comprising a LED such as an infrared LED, or a laser such as a VCSEL, or a laser such as an Edge Emitting Laser (EEL), and a light-receiving sensor 122, for example comprising a photodiode or a plurality of photodiodes, such as SPAD(s), the light-emitting device 112 and the light-receiving sensor 122 being formed over a substrate 102.

The substrate 102 may be a printed circuit board (PCB).

The light-emitting device 112 is configured to emit light signals at a particular frequency or frequency range, and the light-receiving sensor 122 is adapted to detect the emitted light signals in return, for example reflected by an object. In one embodiment, the light-emitting device 112 is configured to emit infrared (IR) light signals, and the light-receiving sensor 122 is adapted to detect the IR light signals in return, for example reflected by an object.

The light-emitting device 112 is included in a first die 110, and the light-receiving sensor 122 is included in second die 120, the first and second dies being mounted on a top surface 102A of the substrate 102.

The first and second dies 110, 120 may be coupled to the substrate 102 using conductive connectors, for example respectively by first and second conductive wires 141, 142. For example, a first end of each first, respectively second, conductive wire is coupled to a conductive pad (not shown in Figures 1A-1D) of the first, respectively second, die, and a second end of each first, respectively second, conductive wire is coupled to a conductive pad on the top surface 102A of the substrate 102. The first and second dies 110, 120 may be secured to the substrate 102, such as by an adhesive material or a solder. The adhesive material may be any material suitable for securing the dies to the substrate, such as tape, paste, glue (not shown in Figures 1A-1D).

The light-emitting device 112 may be electrically coupled to the light-receiving sensor 122, for example through the substrate 102 and the first and second dies 110, 120.

Generally, the optical sensor module 100 comprises a processing device for processing signals received from the light-receiving sensor 122 (not shown in Figures 1A-1D). The processing device may be included in the second die 120 or in another die.

The top surface 102A of the substrate 102 includes first conductive pads 106 which are for example at, or close to, edges of the substrate.

A module cap 130 having a first opening 131 and a second opening 132 is attached, or bonded, to the substrate 102 and is adapted to at least partially enclose, or cover, the first and second dies 110, 120. At least partially means that for example the first and second openings do not cover the first and second dies. The module cap 130 may be substantially opaque to light at the wavelengths used.

For example, the module cap 130 is mounted on an opaque adhesive 104 which is attached to the substrate 102.

The first and second openings are located in a top surface 130A of the module cap 130. The first opening 131 is located over the light-emitting device 112 and the second opening 132 is located over the light-receiving sensor 122. In the illustrated example, the first opening 131 is rectangular and the second opening 132 is circular, but this is not limitative and other forms are possible.

The module cap 130 may include a separation wall 134 between the first die 110 and the second die 120. The separation wall 134 may form an optical isolator for substantially preventing the internal propagation of light beams between the light-emitting device 112 and the light-receiving sensor 122 within the module cap 130. For example, the separation wall 134 defines two cavities, each cavity having one of the first and second openings.

The module cap 130 is a molded cap formed of a molding material, such as a resin, a Liquid Crystal Polymer (LCP), Nylon, or another engineering plastic, compounded with electrically conductive particles dispersed therein for providing electromagnetic interference shielding.

The module cap 130 may be formed using an injection method.

For example, the molding material including the electrically conductive particles is suitable for absorbing electromagnetic waves (EMI absorption).

For example, the molding material including the electrically conductive particles has a high magnetic permeability. Typically, the relative magnetic permeability of the molding material may be higher than 100, although the higher the better for EMI attenuation. As a reference, a high magnetic permeability material is iron (99,8% purity) whose relative permeability is comprised between 100 and 5000, for example equal to about 5000 for a 99,8% purity iron, or more for a more purified iron.

The module cap 130 has preferably a surface and volume resistivity which is low enough to form an EMI shielding, for example a surface resistivity lower than $10^4$ ohms/square.

The resistivity of the module cap 130 may depend on the electrically conductive particles in the molding material, and may also depend on the geometry of the module cap, for example on the length, width and wall thickness of the module cap. For example, to attain a specified minimum level of EMI attenuation, a wall must contain sufficient conductive particles within the molding material forming the wall. The wall thickness, the particle size, material and fill-factor are all factors affecting resistivity and are pertinent to achieving the desired attenuation.

The EMI attenuation effectiveness may also depend on the tool design with which the product is molded. For example, if the tool design has gate positions that allow better flowing of the compounded molding material, the EMI attenuation can be increased.

For example, the electrically conductive particles comprise, but may not be limited to, one or more of the following:

- carbon fibers;
- chopped carbon fibers;
- electroplated carbon fibers, such as Ni-plated carbon fibers;
- carbon nanotubes;
- conductive carbon black particles;
- stainless steel fibers.

The module cap 130 may be painted of plated, for example a metallic layer may be applied as a finishing layer, in order to increase the EMI protection.

The optical sensor module 100 further comprises two cover glasses:

- a first cover glass 151 positioned in the first opening 131, or between the first opening 131 and the light-emitting device 112, and adapted to transmit the light signals emitted by the light-emitting device; and
- a second cover glass 152 positioned in the second opening 132, or between the second opening 132 and the light-receiving sensor 122, and adapted to transmit the light signals reflected towards the light-receiving sensor.

The first cover glass 151 preferably covers the first opening 131. The first cover glass 151 may be attached to the module cap 130. The first cover glass 151 may be positioned inside the module cap 130 as illustrated, or outside the module cap. Similarly, the second cover glass 152 preferably covers the second opening 132. The second cover glass may be attached to the module cap 130. The second cover glass 152 may be positioned inside the module cap 130 as illustrated, or outside the module cap.

The first and/or the second cover glass may comprise, or consist in, an optical filter and/or a single or a plurality of diffractive optical surfaces and/or refractive optical surfaces, for example, but not limited to, a single or a plurality of lenses.

The cavity between the substrate and the module cap and cover glasses may be filled with a material transparent to light at the wavelengths used.

Each of the first and second cover glasses 151, 152 includes an electrically conductive trace 153 which may be embedded in said cover glass. Each of the first and second cover glasses 151, 152 further includes second conductive pads 154 each coupled to an end of the electrically conductive trace of the cover glass. The electrically conductive trace may be called "conductive trace" or "trace" in the following disclosure.

The conductive traces 153 in the first and second cover glasses 151, 152 allow managing EMI respectively in the first and second openings 131, 132 of the module cap 130, for example by providing EMI reflection in said first and second openings.

In a variant, instead of having a conductive trace in each of the first and second cover glasses, only one of the first and second glasses could have a conductive trace.

In a variant, instead of having the first and second cover glasses, the module could have only one of the first and second cover glasses, covering preferably the light-emitting device 112.

The conductive trace material may be one or a plurality of the following materials: copper (Cu), aluminum (Al), tungsten (W), titanium (Ti), gold (Au), indium-tin oxide (ITO) .

Each of the conductive trace may be a fine and/or thin trace, for example having a width less than 1 micrometer and/or a thickness less than 100 nanometers. The width and thickness of each conductive trace may be a trade-off between the EMI protection function and the optical transmittivity of the cover glass. For example, the conductive trace could be thicker or wider where the trace is not likely to affect the desired quality of light transmission, alternatively the trace could be thinner or narrower where the trace is likely to affect the desired quality of light transmission.

The pitch and pattern of the conductive trace can be determined according to the frequencies of the EMI to be managed. For example, the higher frequency, the lower the pitch can be.

The pitch of the trace is for example smaller than the wavelength $\lambda$ of the electromagnetic signal to be attenuated, and is for example a fraction of the wavelength $\lambda$, where $\lambda$ is equal to:

$$\lambda = \frac{v}{f}$$

where v is the speed of light and f is the frequency of the electromagnetic wave chosen to be attenuated.

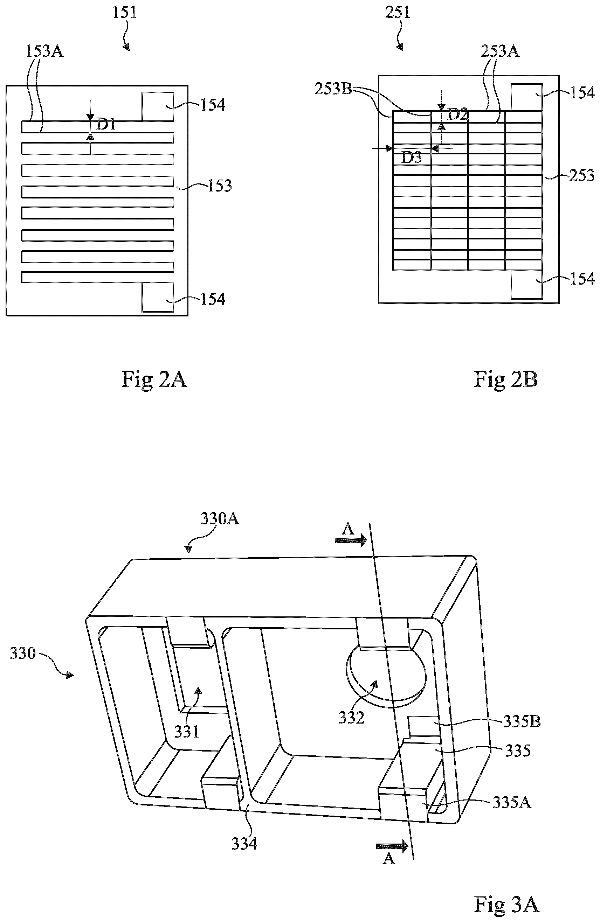

Different patterns of the conductive trace may be contemplated, as illustrated in Figure 2A and Figure 2B.

Figure 2A is a top view of one of the cover glasses of the optical sensor module 100 of Figure 1A. Figure 2A for example shows the first cover glass 151, but it can also apply to the second cover glass 152. The conductive trace 153 of the illustrated cover glass 151 winds in the shape of a zigzag between two second conductive pads 154. This forms a plurality of substantially parallel linear portions 153A of the conductive trace, two parallel linear portions being separated by a distance D1 in one direction of the cover glass plan. D1 is for example smaller than, or equal to, a fraction of the wavelength $\lambda$, as defined above.

Figure 2B is a top view of another cover glass of an optical sensor module according to another embodiment. The conductive trace 253 of the illustrated cover glass 251 comprises several portions forming a mesh, or grid, the mesh having two ends connected to the second conductive pads 154. This forms a plurality of substantially parallel linear portions 253A, 253B of the conductive trace in a first direction and a second direction of the cover glass plan, the first and second directions being substantially perpendicular to each other. Two parallel linear portions are separated by a distance D2 in the first direction and D3 in the second direction. D2 and D3 are for example smaller than, or equal to, a fraction of the wavelength $\lambda$, as defined above.

Advantageously, at least one of the conductive traces is grounded, in order to provide additional EMI protection, for example through the second conductive pads 154.

The optical sensor module 100 further comprises a plurality of conductive leads 135, which are represented as lead frames in Figures 1A-1D, assembled with the module cap 130. The conductive leads 135 are configured and positioned in order to electrically couple the conductive traces 153 of the cover glasses 151, 152 to the substrate 102.

Each lead frame 135 may be a single conductive piece, for example a single metallic piece.

Each lead frame 135 may be inserted into recesses, or channels, 133 formed in the module cap 130.

In a variant, the lead frames may be overmolded during an injection molding operation for forming the module cap. The lead frames are then overmolded in the module cap.

Each lead frame 135 comprises a first end 135A coupled, for example connected, to one of the first conductive pads 106 of the substrate 102 and a second end 135B coupled, for example connected, to one of the second conductive pads 154 of the cover glasses 151, 152. The first end 135A of each lead frame 135 may be coupled to the first conductive pad 106 by a conductive adhesive material 108, for example a conductive tape, paste or glue, or by a conductive solder. The second end 135B of each lead frame 135 may be coupled to the second conductive pad 154 by a conductive adhesive material 155, for example a conductive tape, paste or glue, a conductive solder, or by a conductive wire 156 formed by wire bonding. Although Figures 1B and 1D show a conductive material 155 such as a conductive glue, Figures 1A and 1C show a conductive wire 156.

Examples of conductive wire are described in more detail in the French patent application number 2311572, filed on October 25, 2023 in the name of STMICROELECTRONICS INTERNATIONAL N.V. (law firm reference being B22688) entitled "Optical sensor module", and in the European patent application claiming the priority of the French patent application number 2311572, which are hereby incorporated by reference to the maximum extent allowable by law.

The substrate 102 may comprise a conductive rail (not shown in Figures 1A-1D) configured to be at a fixed voltage, such as ground, so that the conductive traces 153 in the cover glasses 151, 152 can be coupled to the fixed voltage, such as ground, through some of the lead frames 135 and the substrate 102, and for example through some of the first and second conductive pads. This can improve the EMI protection provided by the conductive traces 153.

The optical sensor module 100 may further include common circuitry (not shown in Figures 1A-1D) housed within the module cap 130.

Using such a conductive molded cap provides a significant EMI shielding for the optical sensor module. Using a molded cap allows complex shapes to be formed with close tolerance, and inserting conductive material suitable for EMI shielding inside the molded cap eliminates the need to add an EMI shielding, such as a metal shielding, over the optical sensor module, thereby avoiding enlarging the footprint of the optical sensor module. The method of making the molded cap can be simple, for example using an injection technique.

In addition, using a conductive material suitable for EMI absorption makes electromagnetic waves absorbed, and thus, electromagnetic waves may loss the energy to interfere with other components, as opposed to an electromagnetic wave that is reflected using for example a metal shielding.

The combination of the conductive molded cap and the conductive traces within the cover glasses can provide a large EMI shielding for the optical sensor module, including in the module cap's openings, using absorption, reflection and/or grounding to manage EMI.

By combining a cover glass with an optical surface, such as a lens and/or a filter, the optical sensor module can additionally provide any optical function such as filtering, beam shaping and/or imaging, while reducing the total number of elements in the module.

In a variant, the cover glasses may not include conductive traces and/or the optical sensor module may not comprise conductive leads.

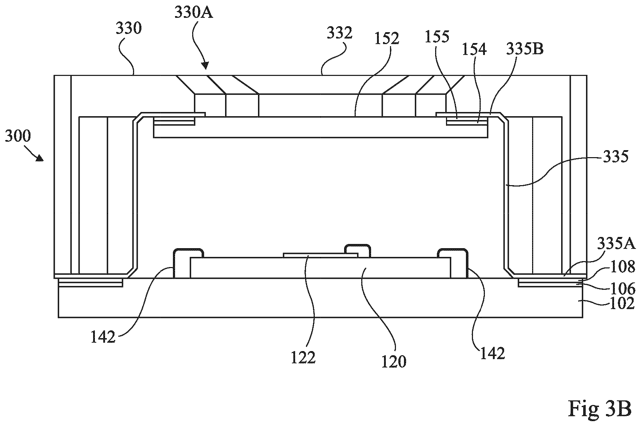

Figure 3A is a 3-dimensional view of a module cap of an optical sensor module 300 according to a further embodiment. Figure 3B is a cross-section view of the optical sensor module of Figure 3A.

The sensor module 300 mainly differs from the optical sensor module 100 of Figure 1A in that, instead of having lead frames inserted into channels in the module cap, the module cap 330 is formed with conductive layers 335 formed on surfaces, for example internal and bottom surfaces, of the module cap, thus forming conductive leads on the module cap. The conductive layers 335 may be coated, or plated, on the module cap, for example formed using a laser direct structuring (LDS) technique.

Each conductive layer 335 comprises a first end 335A coupled, for example connected, to one of the first conductive pads 106 of the substrate 102 and a second end 335B coupled, for example connected, to one of the second conductive pads 154 of the cover glasses 151, 152. The first end 335A of each conductive layer 335 may be coupled to the first conductive pad 106 by a conductive adhesive material 108, for example a conductive tape, paste or glue, or by a conductive solder. The second end 335B of each conductive layer 335 may be coupled to the second conductive pad 154 by a conductive adhesive material 155, for example a conductive tape, paste or glue, or by wire bonding.

The other features of the optical sensor module 300 of Figures 3A and 3B may be similar to that of the optical sensor module 100 of Figures 1A to 1D.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

## Claims

1. An optical sensor module (100; 300) comprising:

   - a light-emitting device (112);
   - a light-receiving sensor (122);
   - a module cap (130; 330) adapted to at least partially cover the light-emitting device and the light-receiving sensor, the module cap being a molded cap;
   - a substrate (102) with which the module cap (130; 330) is assembled, the light-emitting device (112) being included in a first die (110) mounted on the substrate (102), and the light-receiving sensor (122) being included in a second die (120) mounted on the substrate;
   - conductive leads (135; 335) assembled with, or included in, the module cap (130; 330) and coupled to first conductive pads (106) of the substrate; and
   - at least one cover glass (151, 152) covering at least one opening (131, 132; 331, 332) of the module cap, each cover glass comprising a conductive trace (153; 253) providing electromagnetic interference shielding, the conductive trace being coupled to the conductive leads.

2. The module (100; 300) according to claim 1, wherein the molded cap is formed of a molding material comprising electrically conductive particles dispersed therein for providing electromagnetic interference shielding.

3. The module (100; 300) according to claim 2, wherein the module cap is suitable for absorbing electromagnetic waves, and/or has a surface resistivity lower than $10^4$ ohms/square, and/or has a relative magnetic permeability higher than 100.

4. The module (100; 300) according to claim 2 or 3, wherein the module cap is an injection molded cap, and/or the molding material is a resin, a liquid crystal polymer, or another engineering plastic.

5. The module (100; 300) according to any of claims 2 to 4, wherein the electrically conductive particles comprise one or more of the following:

   - carbon fibers;
   - chopped carbon fibers;
   - electroplated carbon fibers, such as Ni-plated carbon fibers;
   - carbon nanotubes;
   - conductive carbon black particles;
   - stainless steel fibers.

6. The module according to any of claims 1 to 5, wherein the module cap includes a metallic finishing layer for increasing electromagnetic interference shielding.

7. The module (100; 300) according to any of claims 1 to 6, wherein the module cap (130; 330) includes a separation wall (134; 334) adapted to separate the light-emitting device (112) and the light-receiving sensor (122).

8. The module (100; 300) according to any of claims 1 to 7, wherein the conductive leads (135; 335) are coupled to the first conductive pads (106) of the substrate using a conductive adhesive material (108) and/or the substrate (102) comprises a conductive rail configured to be at a fixed voltage such as ground, the conductive rail being coupled to the first conductive pads.

9. The module (100) according to any of claims 1 to 8, wherein the conductive leads (135) are lead frames inserted into channels (133) of the module cap (130) or overmolded in said module cap.

10. The module (300) according to any of claims 1 to 8, wherein the conductive leads (335) are conductive layers formed on surfaces of the module cap (330), such as by a direct structuring laser technique.

11. The module (100; 300) according to any of claims 1 to 10, wherein the at least one opening comprises a first opening (131; 331) located over the light-emitting device (112) and a second opening (132; 332) located over the light-receiving sensor (122); and the at least one cover glass comprises:

- a first cover glass (151) positioned in the first opening, or between the first opening and the light-emitting device, and adapted to transmit light signals emitted by the light-emitting device; and
- a second cover glass (152) positioned in the second opening, or between the second opening and the light-receiving sensor, and adapted to transmit light signals reflected towards the light-receiving sensor.

12. The module (100; 300) according to claim 11, wherein the first cover glass (151) and the second cover glass (152) includes each a conductive trace (153; 253) providing electromagnetic interference shielding.

13. The module (100; 300) according to any of claims 1 to 12, wherein each cover glass further includes second conductive pads (154) coupled to the conductive trace (153; 253), the conductive leads (135; 335) being coupled to the second conductive pads, for example using a conductive adhesive material (155).

14. The module (100; 300) according to any of claims 1 to 13, wherein the conductive trace (153; 353) comprises substantially linear portions in parallel with each other and separate with each other by a distance which is smaller than the wavelength of the electromagnetic signal to be attenuated, or is equal to a fraction of said wavelength.

15. The module (100; 300) according to any of claims 1 to 14, wherein the conductive trace material comprises one or a plurality of the following materials: copper, aluminum, tungsten, titanium, gold, indium-tin oxide.

Fig 1A

Fig 1B

Fig 1C

Fig 1D

Fig 2A

Fig 2B

Fig 3A

Fig 3B

Europäisches Patentamt

European Patent Office

Office européen des brevets

# EUROPEAN SEARCH REPORT

**Application Number**

EP 24 20 7091

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/157469 A1 (SAXOD KARINE [FR] ET AL) 23 May 2019 (2019-05-23) * paragraphs [0002], [0056], [0057], [0060], [0064], [0069]; figure 1 * ----- | 1-15 | INV. G01S7/481 H05K9/00 |
| A | US 2019/153179 A1 (GRINSTEINNER DARIN [US]) 23 May 2019 (2019-05-23) * paragraphs [0002], [0011], [0037], [0044], [0053] * ----- | 2-5 | |
| A | US 2022/066036 A1 (SHI WEI [US] ET AL) 3 March 2022 (2022-03-03) * paragraph [0023]; figure 1A * ----- | 10 | |
| Y | US 2020/335641 A1 (DUPEYRAT CYRIL [FR] ET AL) 22 October 2020 (2020-10-22) * paragraphs [0002], [0018], [0021], [0050]; figures 1, 3; table 1 * ----- | 1-15 | |

**TECHNICAL FIELDS SEARCHED (IPC)**

G01S
H05K

The present search report has been drawn up for all claims

| Place of search | Date of completion of the search | Examiner |
|---|---|---|
| Munich | 4 March 2025 | Kirscher, Jérôme |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                    

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 7091

This annex lists the patent family members relating to the patent documents cited in the above-mentioned European search report.
The members are as contained in the European Patent Office EDP file on
The European Patent Office is in no way liable for these particulars which are merely given for the purpose of information.

04-03-2025

| Patent document cited in search report | | | Publication date | Patent family member(s) | | | Publication date |
|---|---|---|---|---|---|---|---|
| US 2019157469 | A1 | | 23-05-2019 | CN | 109830472 | A | 31-05-2019 |
| | | | | CN | 209056485 | U | 02-07-2019 |
| | | | | FR | 3073980 | A1 | 24-05-2019 |
| | | | | US | 2019157469 | A1 | 23-05-2019 |
| | | | | US | 2020303565 | A1 | 24-09-2020 |
| | | | | US | 2022029034 | A1 | 27-01-2022 |
| US 2019153179 | A1 | | 23-05-2019 | CN | 111372987 | A | 03-07-2020 |
| | | | | EP | 3714003 | A1 | 30-09-2020 |
| | | | | JP | 2021503541 | A | 12-02-2021 |
| | | | | KR | 20200079553 | A | 03-07-2020 |
| | | | | US | 2019153179 | A1 | 23-05-2019 |
| | | | | WO | 2019099458 | A1 | 23-05-2019 |
| US 2022066036 | A1 | | 03-03-2022 | CN | 114122904 | A | 01-03-2022 |
| | | | | US | 2022066036 | A1 | 03-03-2022 |
| US 2020335641 | A1 | | 22-10-2020 | CA | 3025328 | A1 | 07-12-2017 |
| | | | | CN | 109769398 | A | 17-05-2019 |
| | | | | EP | 3465759 | A1 | 10-04-2019 |
| | | | | FR | 3051975 | A1 | 01-12-2017 |
| | | | | IL | 263286 | A | 06-01-2019 |
| | | | | JP | 6775608 | B2 | 28-10-2020 |
| | | | | JP | 2019519812 | A | 11-07-2019 |
| | | | | KR | 20190030650 | A | 22-03-2019 |
| | | | | US | 2020335641 | A1 | 22-10-2020 |
| | | | | US | 2021159348 | A1 | 27-05-2021 |
| | | | | WO | 2017207893 | A1 | 07-12-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2311572